# EUROPEAN PATENT SPECIFICATION

(11) **EP 1 887 031 B1**
(45) Date of publication and mention of the grant of the patent: **30.12.2009**
(21) Application number: 06746232.5
(22) Date of filing: 10.05.2006
(51) Int. Cl.: C08J 5/24, B32B 15/08, B32B 5/28, C08G 59/20, H05K 1/03

(54) **WHITE PREPREG, WHITE LAMINATED PLATE, AND METAL FOIL CLAD WHITE LAMINATED PLATE**
WEISSES PREPREG, WEISSE LAMINATPLATTE UND MIT WEISSER LAMINATPLATTE UMMANTELTE METALLFOLIE
PREIMPREGNE BLANC, PLAQUE LAMINEE BLANCHE ET PLAQUE LAMINEE BLANCHE REVETUE DE FEUILLE METALLIQUE

(30) Priority: 12.05.2005 JP 2005140406
(43) Date of publication of application: 13.02.2008
(73) Proprietor: Risho Kogyo Co., Ltd., Osaka-shi, Osaka, 5300003 (JP)
(72) Inventor: OKUMURA, Hiroshi, RISHO KOGYO CO., LTD., Amagasaki-shi Hyogo 6610012 (JP)
(74) Representative: Petraz, Gilberto Luigi
(86) International application number: PCT/JP2006/309422
(87) International publication number: WO 2006/121090

(56) References cited:
- JP-A- 09 143 287
- JP-A- 2000 169 605
- JP-A- 2003 152 294
- JP-A- 2004 115 746
- JP-A- 2006 152 260
- US-B1- 6 329 474
- DATABASE WPI Week 200532 Thomson Scientific, London, GB; AN 2005-309060 XP002522205 & JP 2005 082798 A (NORITAKE CO LTD) 31 March 2005 (2005-03-31)

## Description

### [Field of Art]

The present invention relates to white laminates and metal foil-cladded white laminates useful as print wire boards for mounting light emitting diodes, and to a white prepreg useful for being laminated to manufacture such white laminates and such metal foil-cladded white laminates.

### [Background Art]

In recent years, as observed with regard to mobile phones, all-in-one-video systems, mobile CDs, MD players and the like, not only reduction in weight and thickness are in progress in electronic devices, but added value, such as appearance, operability and visibility are also being demanded. In order to meet these demands, many luminous elements of high visual effect are used and these luminous elements use light emitting diodes (hereinafter referred to LEDs) of miniature and low power consumption.

By the way, blue and white color LEDs have gone into actual use with recent technology progress in addition to conventional red, yellow and green color LEDs; and a demand for blue and white color LEDs is particularly increasing sharply. Further, in recent years, increase in intensity of LED is proceeding and even ultra high intensity LEDs started to be in use.

While LEDs of shell shape type which luminous element part being sealed with resin have been mainly used conventionally; use of chip LEDs where elements are directly mounted on the surface of the substrate has increased recently accompanied with downsizing and thinness for electronics devices. Such chip LEDs had a problem of low luminous intensity compared with shell shape type LEDs; but luminous intensity thereof has become, at present, the same level as that of shell shape type LEDs, by subsequent improvement. Increase in luminous intensity of chip LEDs has make it possible to utilize Chip LEDs as surface light source with high density integration of chip LEDs. Such surface light source is favorable for backlight of liquid crystal display which requires low-profile, and as for other applications it may be applied for lightings for guidance indication, emergency exit lightings, lightings for advertisement as lighting fixtures of surface light type, and the like.

In the mean time, for mechanism of luminescent, there are a combination type of blue light emitting diode and yellow fluorescent element, a combination type of the three primary colors of red, blue and green, or a combination type of UV (ultraviolet light) emitting device and fluorescent element.

As print wire boards for mounting LED devices, there have been conventionally used laminates obtainable by pressure molding under heating of layers (prepregs) of sheet glass fiber substrate impregnated with thermosetting resin. Especially in blue and white chip LEDs, reflection of visible light shorter wavelength area is important, and white compositions containing titanium dioxide as colorant pigment added to thermosetting resin have been conventionally used.

### [Disclosure of the Invention]

### [Problems to be solved by the Invention]

White laminates for print wire boards heretofore, however, have problems of discoloring of thermosetting resin portion and reduction of reflectance, caused by long use and heat during processing. Particularly LEDs of type using UV emitting device have not been appropriate in mounting recent high luminous intensity LED, since substrate on which the LED chip is mounted is deteriorated and discolored by UV. Therefore, a requirement for substrates which are not discolored towards UV and heat is becoming strong. Further, at mounting chip LED, accuracy of board thickness is also required in order to avoid liquid leakage during sealing process of the chip LED, and substrates having both the features have been sought.

### [Means for solving the Problems]

Hence, the inventors have done deep study in order to solve the above problems, and, as the result, have attained, according to the present invention, a white prepreg for print wiring boards providing very little discoloration towards heat or UV and very little reflectance reduction, as well as white laminates laminated with one sheet or plural sheets of such white prepreg, and metal foil-cladded white laminates further having a metal foil disposed thereon. Such white laminates and metal foil-cladded white laminates thus attained are also of high heat resistance, good accurate in board thickness and excellent processability.

In order to solve the above problems, the present invention is comprised of the following embodiments (1) to (13).
(1) The white prepreg according to the present invention is characterized in that it comprises a dried product of a resin composition (E) impregnated on a sheet glass fiber substrate; said composition (E) containing, as essential ingredients, an epoxy resin (A) comprising a cycloaliphatic epoxy resin CA1), a glycidyl (meth)acrylate polymer (B), a white pigment (C), and a curative (D).
(2) The white prepreg of this invention is preferably characterized in that said epoxy resin (A) comprising a cycloaliphatic epoxy (A1) contains an epoxy resin (A2) of general purpose type, selected from the group consisting of a diglycidyl ether of a bisphenol, a novolac of a phenol, a glycidyl amine and a glycidyl ester, in an amount of 5 to 60 % by weight within said epoxy resin (A).
(3) The white prepreg of the invention is preferably characterized in that said resin composition (E) is composed of 20 to 85 % by weight of (A), 5 to 40 % by weight of (B) and 10 to 75 % by weight of (C), and contains (D) in an equivalent ratio of 0.5 to 2 per 1 equivalent of epoxy group contained in (E).
(4) The white prepreg of the invention is preferably characterized in that said cycloaliphatic epoxy (A1) has a structure represented by the following formula (1): 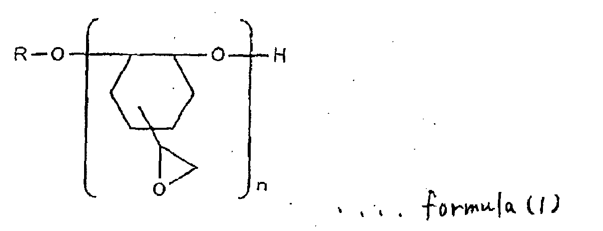 wherein R represents hydrogen or an alkyl group of straight chain or branched chain containing 1 to 5 carbon atoms, and n represents an integer of 1 to 30.
(5) The white prepreg of the invention is preferably characterized in that said glycidyl (meth)acrylate polymer (B) is a glycidyl (meth)acrylate homopolymer.
(6) The white prepreg of the invention is preferably characterized in that said glycidyl (meth)acrylate polymer (B) is a copolymer of glycidyl (meth)acrylate with a radical polymerizaable monomer.
(7) The white prepreg of the invention is preferably characterized in that said white pigment (C) is one, selected from the group consisting of zinc oxide, calcium carbonate, titanium dioxide, alumina and synthetic smectite, or a combination of two or more of them.
(8) The white prepreg of the invention is preferably characterized in that said white pigment (C) is titanium dioxide.
(9) The white prepreg of the invention is preferably characterized in that said curative (D) is a latent curative.
(10) The white laminate according to the present invention is preferably characterized in that it comprises a product obtainable by pressure molding under heating of one sheet or plural sheets of a white prepreg as described in the above (I) to (9).
(11) The metal foil-cladded white laminate according to the present invention is preferably characterized in that it comprises a product obtainable by pressure molding under heating of a laminate of one sheet or plural sheets of a white prepreg as described in the above (1) to (9), having a metal foil disposed thereon.
(12) The white laminate as described in the above (10) is preferably used as a print wire board for mounting a chip type light emitting diode.
(13) The metal foil-cladded white laminate as described in the above (11) is preferably used as a print wire board to mount a chip type light emitting diode.

### [Effects of the Invention]

According to the present invention, it is possible to provide a white prepreg for print wire boards, white laminates and metal foil-cladded white laminates, exhibiting high reflectance of visible light area, and besides very little discoloration towards heat and UV, together with excellent heat resistance and excellent accuracy in board thickness.

### [The Best Mode to implement the Invention]

In the white prepreg of the present invention, it is essential that the epoxy resin (A), which is one of the constituting components of the resin composition (E) impregnated into the sheet glass fiber substrate, is comprised of a cycloaliphatic epoxy resin (A1). Cycloaliphatic epoxy resin (A1) is one of thermosetting resins and quite effective as a countermeasure to anti-UV, and makes it possible to obtain a white prepreg, white laminates and metal foil-cladded white laminates, of very little deterioration and discoloration towards UV and very little decline of reflectance. Among cycloatiphatic epoxy resins (A1), ones providing cured products of high glass transition temperature are preferably used in order to attain high heat resistance. It is preferred that cured products of the resin have a glass transition temperature in the range of 150 to 300°C, particularly in the range of 180 to 250°C.

Generally, cycloaliphatic epoxy resins (A1) include, for example, diglycidyl ethers of hydrogenated bisphenol A , and cyclohexene oxides, as well as cyclocliphtic epoxy resins (represented by the structural formula (1)) having epoxy groups directly bound to a condensate of cyclohexane derivative.

Epoxy resins of hydrogenated bisphenol A diglycidyl ether type as above, however, are of low reactivity, and provide cured products of generally low glass transition temperature such 120°C, depending on curative. Epoxy resins of cyclohexene oxide type are also of low reactivity, though they provide cured products of high glass transition temperature (generally around 180°C to 200°C). Any of these cycloaliphatic epoxy resins may be applied to the present invention, through selecting acid anhydride curatives; since these are well known to provide high resistance to UV. Cycloaliphatic epoxy resins (A1) represented by the above structural formula (1) are most preferred for use as epoxy resin (A) in the present invention, since they provide excellent heat resistance and resistance to UV.

As cycloaliphatic epoxy resins (A1) have low melt viscosity and may cause a problem of worsening accuracy of board thickness at molding the prepreg under pressure and heat; it is preferred, in the white prepreg of this invention, to blend another epoxy resin with a cycloaliphatic epoxy resin (A1), rather than using (A1) alone, as epoxy resin (A) in resin composite (E) to be impregnated in the sheet glass fiber substrate.

Epoxy resin (A) in the present invention may contain added thereto a general purpose epoxy resin (A2) in order to improve the above-mentioned deficiency and manufacturing cost. Namely, the ratio of cycloaliphatic epoxy (A1) in epoxy resin (A) may be reduced and the remnant may be replaced with a general purpose epoxy resin (A2). It is preferred to add a general purpose epoxy resin (A2) in an amount of 5 to 60 % by weight, within epoxy resin (A), particularly 30 to 50 % by weight. When it is used in an amount of 60 % by weight or less within epoxy resin (A), effects by using a cycloaliphatic epoxy resin (A1) are not lowered, that is, deterioration and discoloration will not occur easily by heat or UV.

General purpose epoxy resins (A2), which may be added in epoxy resin (A) of the present invention, are not particularly restricted and include, for example, types of diglycidyl ethers of bisphenols (bisphenol A, F, or S etc.), novolacs of phenols (phenol, cresol etc.), glycidyl amines and glycidyl esters. Preferred are diglycidyl ethers of bisphenols (especially bisphenols A and F), in view of well-balanced cost and performance.

In the while prepreg of the present invention, the epoxy resin (A) comprising cycloaliphatic epoxy (A1), which is one of structural components of the resin composition (E) to be impregnated in sheet glass fiber substrate, is preferably contained in an amount of 20 to 85 % by weight, based on the non-volatile components of the resin composition (E). It is possible to attain effects as mentioned above, if the epoxy resin (A) is contained in an amount of 20% by weight or more; while, if the epoxy resin (A) is contained in an amount of 85% by weigh or less, there is no possibility of problem of worsening accuracy in board thickness at molding the prepreg under pressure and heat arisen from low melt viscosity of cycloaliphatic epoxy (A1), and no disadvantage is caused in terms of manufacturing cost.

It is essential in the while prepreg of the present invention to add a glycidyl (meth) acrylate polymer (B) in the resin composition (E) which is impregnated in sheet glass fiber substrate. By using (B), are attained improved pigment dispersability of the resin composition (E) and improved flow properties of resin at the time of prepreg molding; and there can be avoided the above-mentioned problems of worsening accuracy of board thickness at molding prepreg under pressure and heat, arisen from low melt viscosity of cycloaliphatic epoxy (A1). Improvement in pigment dispersability provides improved appearance, while improvement in flow properties of resin at molding imparts improved accuracy of the substrate thickness of laminate boards.

Among glycidyl (meth)acrylate polymers (B) as above, preferred in view of enhancing heat resistance are glycidyl (meth)acrylate homopolymers or copolymers of glycidyl (meth)acrylate with a radical polymerizable monomer, preferably having an epoxy equivalent weight of around 100 to 1000g/eq, and having a weight-average molecular weight within the range of 200 to 250,000. The copolymerization ratio of the radical polymerization monomer is preferably within range of 5 to 75 % by weight to glycidyl (meth) acrylate. Suitable radical polymerization monomers include, for example, styrene, acrylate derivatives such as methyl (meth)acrylates, cyclohexyl (meth) acrylates, and the like.

It is preferred to add the glycidyl (meth)acxylate polymer (B) in a content of 5 to 40 % by weight within the resin composition (E). In case of adding the aforementioned general purpose resin (A2), decline of heat resistance and phase separation within the cured products of cycloaliphatic epoxy (A1) and general purpose resin (A2) are suppressed through adding the glycidyl (meth) acrylate polymer (B) in a content of 5 % by weight or more to the resin composition (E), and especially addition of 10 to 20 % by weight is preferred to attain most effective results. Besides, addition of 40 % by weight or less results in no adverse effects in impregnating properties of the resin composition (E) into the sheet glass fiber substrate.

It is required to add white pigment (C) to the resin composition (E) in the present invention. White pigments (C) to be added are not particularly restricted as far as they are white inorganic powders; and include, for example, zinc oxide, calcium carbonate, titanium dioxide, alumina and synthetic smectite. It is most preferred to use titanium dioxide, in view of visible light reflectance and whiteness, or electric characteristics.

For titanium dioxide crystal structures, there are an anatase type and a rutile type. Listing characteristics of both types, the anatase type has a good reflectance of visible light shorter wavelength area, while the rutile type has excellent durability and color fastness for a long time. Both of them are acceptable for the white pigment (C) to be added to resin composition (E) in the present invention, without any special restriction. Mixed use of the both is naturally is possible.

It is preferred to use white pigment (C) contained in the resin composition (E) in a content of 10 to 75 % by weight within the resin composition (E) of the present invention. It is possible to attain sufficient whiteness and reflectance at the content of 10 % by weight or more, while the content of 75 % by weight or less will not occur any problems such as declining of impregnating ability in the sheet glass fiber substrate and declining of adhesive strength with metal foil.

In case titanium dioxide is used as white pigment (C), titanium dioxide may be surface-treated through treatment with alumina, silica or the like. There may also be used treatment with a silane coupling agent or a titanate coupling agent.

Resin composition (E), impregnated in the sheet glass fiber substrate, may optionally contain an inorganic filler, such as silica, other than the above white pigment (C). Suitable inorganic fillers, to be contained, include, for example, silica, aluminum hydroxide, magnesium hydroxide, E glass powder, magnesium oxide, potassium titanate, calcium silicate, clay, talc and the like. These may be used alone or in combination of two or more of them. By including these inorganic fillers, modulus elasticity of the substrate is enhanced. There is no restriction for loadings specially, it is preferable to be 50 % by weight or less to resin composition (E). When the content is 50 % by weight or less, there will be little possibility of problems such as declining of impregnating ability in the sheet glass fiber substrate and declining of adhesive strength with metal foil.

Resin composition (E), impregnated in the sheet glass fiber substrate, may optionally contain a fluorescent agent compounded thereto, besides the above white pigment (C) and inorganic filler. By compounding a fluorescent agent, apparent reflectance in visible light of shorter wavelength area may be increased. Fluorescent agents are compounds having properties of absorbing light energies, such as light, radiation, UV and the like, and converting them into other lights of different wavelengths to radiate these lights. Exemplary of organic fluorescent substances are diaminostilbene derivatives, anthrasene, sodium salicylate, diaminostilbene disulfonic acid derivatives, imidazole derivatives, coumarin derivatives, pyrazoline derivatives, decalylamine derivatives and the like. Inorganic fluorescent substances are inclusive of ZnCdS: Ag, ZnS: Pb, ZnS: Cu and the like. It is preferable for fluorescent agent to have radiation wavelength at visible light of shorter wavelength area (380 to 470nm) where decline of reflectance is notable. Among the above mentioned fluorescent agents, preferred are those generally called fluorescent bleaches, such as diaminostilbene disulfonic acid derivatives, imidazole derivatives, coumarin derivatives and pyrazoline derivatives. As for its loadings, there is no special restriction. In case of pyrazoline derivatives, effects are exhibited through loading of 0.1 % by weight to resin composition, and more the loadings higher effects. Besides, fluorescent bleach to be added is desirable to be soluble in solvent.

Curative (D) is required for the epoxy resin system to be used for the present invention. Curatives for epoxy resin include primary amines (such as diamino diphenyl sulfone (hereinafter referred to as "DDS") and the like), secondary amines, and tertiary amines; and, besides, acid anbydrides and derivatives thereof as well as photo-setting agents, such as aromatic diazonium salts and aromatic sulfonium salts.

Curative (D) to be used for the present invention is not particularly restricted as long as it is within curatives as mentioned above. In case of using, as cycloaliphatic epoxy resin (A1), one represented by the structural formula (1); it is preferred to use a latent curative, such as dicyandiamide (hereinafter referred to as "DICY").

Latent curatives here means ones which perform function as curative when temperature exceeds a certain level to cure thermosetting resin. Such temperature is generally called "activation temperature", and curing of thermosetting resin does not occur essentially at temperature below the activation temperature. While relevant activation temperature is not specified especially, it is preferred from a practical standpoint in view making it easy to handle that activation temperature is in the range of 80 to 170°C.

Suitable latent curatives which may be used, include, besides DICY as mentioned above, urea curatives, organic acid hydrazide curatives, polyamine salt curatives, amine adduct curatives and so on.

Loadings of curative (D), which may vary depending on the type of curative, generally it is preferable to be in such a ratio obtained from epoxy equivalent and amine (acid) equivalent. Namely, the loadings ratio of curative to epoxy resins ((A1) + (A2) +(B)) in resin composition (E) to be used for the white prepreg of the present invention is desirable to be loadings of curative within a ratio of 0.5 to 2 equivalent per 1 equivalent of epoxy group.

In case of using DICY as curative (D), there may also be added optionally a curing accelerator, such as a tertiary amine or an imidazole, besides the curative. Imidazoles include, for example, 2-methyl imidazole, 2-ethyl-4methyl imidazole, 2-phenyl imidazole, 1-cyanoethyl -2-unclecyl imidazole and 2-phenyl-4-methyl imidazole. Loadings of the curing accelerator of 0.05 to 5 % by weight level to the epoxy resins and the curative ((A1) + (A2) + (B) + (D)) is suitable.

Sheet glass fiber substrates to be used for the white prepreg of the present invention may be any of glass cloth and unwoven fabric, or a combination of glass cloth with unwoven fabric. In case of glass cloth, structures thereof are not particularly restricted, and are inclusive of plain weave structure, which is basic one, and cloth structures, such as mat weave, satin weave, twill weave and the like. It is preferable to use weaving structure of small gap at crossing part between warp and weft yarn in order to avoid worsening of appearance and processability. Thickness of glass cloth is not particularly restricted. Ones having a thichness in the range of 0.02 to 0.3mm are easy to handle and preferable.

Besides, sheet glass fiber substrates may be surface-treated with a silane coupling agent or the like. Further, a sheet glass fiber substrate itself colored in white may be used.

White prepregs of the present invention can be prepared by adding a solvent such as methyl ethyl ketone to a resin composition as described above to prepare a resin varnish, followed by impregnating the varnish into a sheet glass fiber substrate comprised of glass cloth or the like and then drying the vanish-impregnated substrate. Methods for impregnating the resin composition into the sheet glass fiber substrate and drying it are not particularly restricted; and there may be adopt, for instance, a method which comprises impregnating the sheet glass fiber substrate with the resin composition through immersing or the like, followed by heating them to a temperature in the range of around 100°C to 180°C to remove the solvent and semi-cure the epoxy resins. Impregnated amount of the resin composition of the white prepreg, obtained by impregnating it to the sheet glass fiber substrate and drying it, is not particularly restricted. It is preferred to make it in an amount of 30 to 60 % by weight.

White laminates of this invention can be manufactured by molding, under heat and pressure, one sheet of a white prepreg thus obtained or one obtainable by laminating multiple sheets thereof. Besides, metal foil-cladded white laminates of the present invention may be manufactured by disposing and laminating a metal foil with one sheet of a white prepreg, thus obtained or one obtainable by laminating multiple sheets thereof, followed by molding them under heat and pressure. While there is no special restriction for the number of sheets to be superimposed, generally one sheet of a white prepreg or 2 to 10 sheets thereof are superimposed for single layer substrates; and, in case of metal foil-claded white laminates, a metal foil is disposed thereon, or metal foils are disposed thereon and thereunder. Multi-layer substrates may be manufactured by laminating plural sheets of a single substrate as above, wherein the number of sheets to be superimposed is not particularly restricted. Suitable metal foils to be used include, for example, copper foil and aluminum foil. Besides, thickness of metal foil is generally 3 µm to 105 µm, and especially it is preferable to be 12 µm to 35 µm. In addition, the white prepreg of the present invention may be used for only a surface layer, using a prepreg of prior art for inner layers. White laminates and metal foil-cladded white laminates thus obtained according to the present invention have high reflectance of visible light area, besides exhibit remarkable little discoloration towards heat and UP, and provide white laminates and metal foil-cladded white laminates for print wire boards with excellent accurate board thickness and high heat resistance.

Print wire boards can be produced by forming a conductive pattern on a white laminate thus obtained through Additive Technique. Print wire boards may also be produced by printing a circuit pattern on the metal foil of a metal foil-cladded white laminate followed by implementing etching thereon. In order to implement a chip LED on a print wire board as above, a solder is coated on the print wire board at first, and then the chip LED is mounted thereon, followed by fixing the chip LED on the print board by melting the solder through reflow soldering. Chip LEDs become applicable for surface light source, through high density integration; and such surface light source is suitably utilized as backlight for liquid displays, in which thinness is especially required. Other applications include lighting devices of surface emitting type, such as guidance display lightings, emergency exit lightings, advertising lightings, and the like.

Accuracy in board thickness of substrates for mounting chip LED is extremely important in sealing devices mounted on the substrate by transfer molding. The transfer molding here means a method of introducing a resin under pressure into a mold clamped die. Thickness of substrates to be used for chip LED is generally between 0.06mm and 1.0mm. In case of poor accuracy in board thickness, during the transfer molding, clearance between the substrate and the die at molding clamping is created to result in molding defects caused by leaking out of the introduced resin through the clearance. In such transfer molding, accuracy required for the board thickness is, for example, in case of a substrate of 1.0mm thickness, within the allowance of ± 0.05mm or less (the range is 0.1mm), preferably within the allowance of ±0.03mm or less (the range is 0.06mm). Therefore, substrates with highly accurate board thickness are capable of providing considerably reduced rejection rate in manufacturing process of chip LEDs, and are industrilally of great use.

### [Examples]

The contents and the effects of the present invention are explained by Examples below. The present invention shall not be limited to the following Examples, within the scope of its gist.

### [Example 1]

Into 50 pbw of methyl ethyl ketone (hereinafter referred to as "MEK"), were dissolved 50 pbw (parts by weight) of a cycloaliphatic epoxy resin: EHPE-3150 (made by Daicel Chemical Industries, Ltd.), 40 pbw of a bisphenol A epoxy resin: AER-6051EK75 (made by Asahi Kasei Corporation), and 10 pbw of a glycidyl metharylate copolymer: Merproof G-0150M (made by NOF Corporation) to prepare a varnish (Varnish A).
Into 25 pbw of dimethylformamide (hereinafter referred to as "DMF"), were dissolved 3 pbw of DICY as curative, 0.1 pbw of C11Z-CN (1-cyanoethyl-2-undecyl imidazole, made by Shikoku Chemicals Corporation) as curing accelerator to prepare a varnish (Varnish B).
Varnish A and Varnish B were mixed, and 73 pbw of rutile titanium dioxide R-21 (made by Sakai Chemical Industry Co., Ltd.) as white pigment, 0.3 pbw of HR-10 (pyrazoline derivative, radiation wavelength: 450nm made by Chuo Synthetic Chemical Co., Ltd.) as fluorescent bleach were added thereto, followed by stirring them for one hour at room temperature to obtain a white epoxy varnish.
This white epoxy varnish was impregnated into a glass cloth with thickness of 0.1mm WEA-116E (made by Nitto Boseki Co., Ltd.), followed by preliminarily drying them for 5 minutes at 150°C to obtain a prepreg containing 50% of the resin composition. Copper foils with thickness of 18 µ m were overlaid on and backside of each of one sheet of this prepreg and ones obtained by laminating four and ten sheets of this prepreg, followed by molding them under pressure of 40kg/cm² and heat with temperature of 170°C to obtain metal foil-cladded white laminates with thickness of 0.1mm, 0.4mm and 1mm, respectively.

### [Comparative Example 1]

White laminates were obtained in the same manner as in Example 1 with varying the composition of the white epoxy varnish as follows:
Into 40 pbw of MEK, were dissolved 50 pbw of a bisphenol A epoxy resin:
AER-6051EK75 (made by Asahi Kasei Corporation) and 50 pbw of a creosol novolac epoxy resin: YDCN-704 (made by Tohto Kasei Co., Ltd.) to prepare a varnish (Varnish C).
Into 30 pbw of DMF, were dissolved 19 pbw of DDS as curative, 0.4 pbw of 2P4MZ (2-phenyl-4-methyl imidazole made by Shikoku Chemicals Corporation) as curing accelerator to prepare a varnish (Varnish D).
Varnish C and Varnish D were mixed, and 73 pbw of anatase titanium dioxide TA-500 (made by Fuji Titanium Industry Co., Ltd.) as white pigment and 0.3 pbw of HR-101 (made by Chuo Synthetic Chemical Co., Ltd.) as fluorescent bleach were added thereto to obtain a white epoxy varnish.
In the same manner as in Example 1, a prepreg was prepared using the resulting white epoxy varnish, and the prepreg was laminated, followed by overlaying copper foils on and backside of the laminates thus obtained and then molding under pressure and heat to obtain metal foil-cladded white laminates with thickness of 0.1mm, 0.4mm and 1mm, respectively.

### [Verification test for effects]

### 1) Heat discoloration resistance

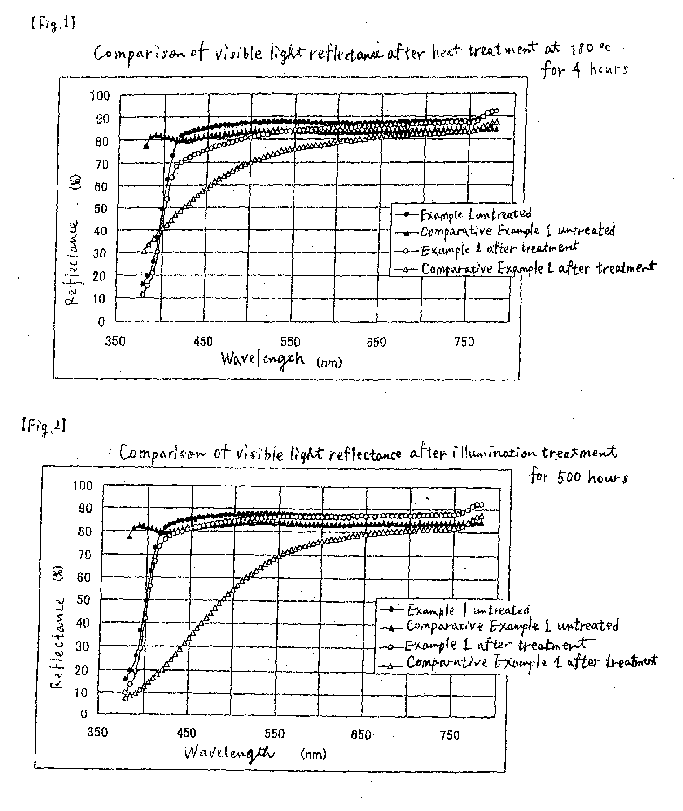

After removing copper foil, through etching treatment, from the metal foil-cladded white laminates having thickness of 0.1mm obtained in Example 1 and Comparative Example 1; visible light reflectance of the surface of the resulting substrates was measured in accordance with JIS-Z8722, and further visible light reflectance was measured in the same manner after heat treatment for 4 hours at 180°C.
The results were as shown in Fig. 1. As apparent from Fig. 1, the substrate in Example 1 shows less deterioration at the shorter wavelength area and improved heat resistance, as compared with the substrate in Comparative Example 1.

### 2) Resistance to UV.

After removing copper foil, through etching treatment, from the metal foil-cladded white laminates having thickness of 0.1mm obtained in Example 1 and Comparative Example 1; visible light reflectance of the surface of the resulting substrates was measured in accordance with JIS-Z8722, and further visible light reflectance was measured in the same manner after illuminating the substrate with high pressure mercury lamp light (luminescence emission spectrum of UV portion: 253.7nm, 365nm) at a distance of 45cm (illumination intensity=around 6W/m') for 500 hours.
The results were as shown in Fig. 2. As apparent from Fig. 2, the substrate in Example 1 shows less deterioration at the shorter wavelength area and improved resistance to UV, as compared with the substrate in Comparative Example 1.

### 3) Glass transition temperature

Glass transition temperature was determined in accordance with JIS-C6481. Namely, after removing copper foil, through etching treatment, from the metal foil-cladded white laminates having thickness of 0.4mm obtained in Example 1 and Comparative Example 1; a specimen of 7mm×70mm in size was cut out therefrom; and glass transition temperature was determined from the peak temperature of loss tangent of the measurement data, obtained through measurement of the specimen at temperature increase speed of 2°C/min. with use of a free decay type dynamic viscoelasticity measuring equipment (Model No. AD·11000AD made by Rhesca Co., Ltd.).
The white laminates (after removing metal foil) in Example 1 and Comparative Example 1 had glass transition temperature of 200°C and 190°C, respectively. From the results, both the white laminates in Example 1 and Comparative Example 1 had heat resistance enough for practical use, and among them the white laminate in Example 1 shows better heat resistance.

### 4) Accuracy in board thickness

Board thickness of the metal foil-cladded white laminates having thickness of 1mm (1000mm × 1000mm) obtained in Example 1 and Comparative Example 1 were measured, with a micrometer of 1/1000mm, at 60 positions in total with interval of every 250mm longitudinally and every 70mm horizontally, to determine the range of board thickness and the difference between the maximum value and the minimum value.
The board thickness data of the metal foil-cladded white laminates of Example 1 and Comparative Example 1 are shown in Table 1. The difference between the maximum value and the minimum value of the board thickness in Example 1 and Comparative Example 1 were 0.055mm and 0.115mm, respectively.
AS apparent from the results, the metal foil-cladded white laminate of Example 1 shows improved accuracy in board thickness, as compared with that of Comparative Example 1, and sufficiently meets accuracy requirements.

**[Table 1]**

| Board thickness data in Example 1 and Comparative Example 1 | | | | | | | | |
|---|---|---|---|---|---|---|---|---|
| | Example 1 | | | | Comparative Example 1 | | | |
| Actual measurement (mm) | 0.998 | 1.022 | 1.005 | 0. 989 | 1.009 | 1.009 | 0.997 | 1.011 |
| | 0.992 | 0.980 | 1.025 | 1.012 | 1. 024 | 1. 001 | 0. 992 | 0. 999 |
| | 0.976 | 1.003 | 1.031 | 1.010 | 1.004 | 1.007 | 0.985 | 0.993 |
| | 1.015 | 1.007 | 0.988 | 1.011 | 0.979 | 0.992 | 0.992 | 1.000 |
| | 0.994 | 1.006 | 1.018 | 0.997 | 0.978 | 0.982 | 0.987 | 1.010 |
| | 0.978 | 1.03 | 1.002 | 0.996 | 0.998 | 1.001 | 0.996 | 1.015 |
| | 0.989 | 1.004 | 0.992 | 0.987 | 0. 992 | 1.006 | 0.994 | 1. 002 |
| | 1.029 | 0.998 | 0.999 | 0.998 | 0.979 | 0.978 | 0.994 | 0.995 |
| | 1.026 | 1.029 | 1.022 | 0.979 | 0.989 | 0.988 | 0.989 | 1.012 |
| | 0.992 | 0. 999 | 1.012 | 0.999 | 0.998 | 1.007 | 1.006 | 0. 939 |
| | 0.992 | 1.011 | 0.985 | 1.022 | 0.994 | 1.022 | 0.980 | 0.926 |
| | 0.992 | 0.992 | 0.993 | 0.995 | 1.007 | 1.025 | 0.953 | 0.910 |
| | 1. 003 | 1. 011 | 0.991 | 1.012 | 1.020 | 0.975 | 0.996 | 0.991 |
| | 1.000 | 0.994 | 0.982 | 1.031 | 1. 003 | 0. 949 | 0.987 | 0.992 |
| | 0.996 | 1.002 | 0.987 | 0.987 | 1.001 | 0.992 | 0.952 | 0.913 |
| Range of board thickness (Max, value-Min value) (mm) | 0.976∼1.031 (0.055) | | | | 0.910∼1.025 (0.115) | | | |

### [Possibility for industrial utilization]

As described above, according to the present invention, it is capable of providing white prepregs, white laminates and metal foil-cladded white laminates for print wiring board, exhibiting high reflectance in visible light area, with substantially little discoloration towards heat and UV, together with high heat resistance and excellent accuracy in board thickness; and the present invention contributes substantially to the industries.

### [Brief summary of Drawings]

[Fig. 1] Comparison of visible light reflectance after heat treatment at 180°C for 4 hours
[Fig. 2] Comparison of visible light reflectance after illumination treatment for 500 hours by high pressure mercury (400W) lamp light (major luminescent wavelength of UV 253.7nm and 365nm, illumination intensity: around GW/m²)

## Claims

1. A white prepreg, which comprises a dried product of a resin composition (E) impregnated on a sheet glass fiber substrate; said composition (E) containing, as essential ingredients, an epoxy resin (A) comprising a cycloaliphatic epoxy resin (A1), a glycidyl (meth)acrylate polymer (B), a white pigment (C), and a curative (D).

2. The white prepreg as described in Claim 1, wherein said epoxy resin (A) comprising a cycloaliphatic epoxy (A1) contains an epoxy resin (A2) of general purpose type, selected from the group consisting of a diglycidyl ether of a bisphenol, a novolac of a phenol, a glycidyl amine and a glycidyl ester, in an amount of 5 to 60 % by weight within said epoxy resin (A).

3. The white prepreg as described in Claim 1 or Claim 2, wherein said resin composition (E) is composed of 20 to 85 % by weight of (A), 5 to 40 % by weight of (B) and 10 to 75 % by weight of (C), and contains (D) in an equivalent ratio of 0.5 to 2 per 1 equivalent of epoxy group contained in (E).

4. The white prepreg as described in any one of Claims 1 to 3, wherein said cycloaliphatic epoxy (A1) has a structure represented by the following formula (1): 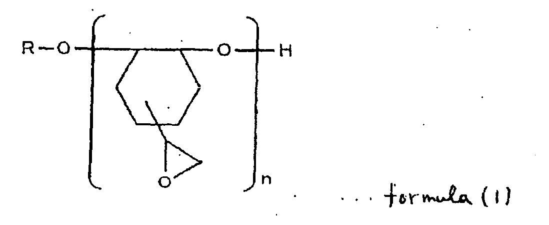 wherein R represents hydrogen or an alkyl group of straight chain or branched chain containing 1 to 5 carbon atoms, and n represents an integer of 1 to 30.

5. The white prepreg as described in any one of Claims 1 to 4, wherein said glycidyl (meth)acrylate polymer (B) is a glycidyl (meth)acrylate homopolymer.

6. The white prepreg as described in any one of Claims 1 to 4, wherein said glycidyl (meth)acrylate polymer (B) is a copolymer of glycidyl (meth)acrylate with a radical polymerizaable monomer.

7. The white prepreg as described in any one of Claims 1 to 6, wherein said white pigment (C) is one, selected from the group consisting of zinc oxide, calcium carbonate, titanium dioxide, alumina and synthetic smectite, or a combination of two or more of them.

8. The white prepreg as described in any one of Claims 1 to 6, wherein said white pigment (C) is titanium dioxide.

9. The white prepreg as described in any one of Claims 1 to 8, wherein said curative (D) is a latent curative.

10. A white laminate, which comprises a product obtainable by pressure molding under heating of one sheet or plural sheets of a white prepreg as described in any one of Claims 1 to 9.

11. A metal foil-cladded white laminate, which comprises a product obtainable by pressure molding under heating of a laminate of one sheet or plural sheets of a white prepreg as described in any one of Claims 1 to 9, having a metal foil disposed thereon.

12. A print wire board for mounting a chip type light emitting diode, said board comprising a white laminate as described in Claim 10 used therein.

13. A print wire board for mounting a chip type light emitting diode, said board comprising a metal foil-cladded white laminate as described in Claim 11 used therein.

## Patentansprüche

1. Ein weißes Prepreg, welches ein getrocknetes Produkt einer Harzzusammensetzung (E) umfasst, die in eine Glasfaserlage imprägniert wurde, wobei die besagte Zusammensetzung (E) als wesentliche Bestandteile ein Epoxyharz (A) mit einem cycloaliphatischen Epoxyharz (Al), ein Glycidyl(meth)acrylat-Polymer (B), ein weißes Pigment (C) und einen Härter (D) umfasst.

2. Das weiße Prepreg gemäß Anspruch 1, **dadurch gekennzeichnet, dass** das besagte Epoxyharz (A) mit einem cycloaliphatischen Epoxy (Al) ein allgemein verwendbares Epoxyharz (A2) umfasst, ausgewählt aus der Gruppe bestehend aus einem Diglycidylether eines Bisphenols, einem Novolak eines Phenols, einem Glycidylamin und einem Glycidylester, in einer Menge von 5 to 60 Gewichtsprozent, bezogen auf besagtes Epoxyharz (A).

3. Das weiße Prepreg gemäß Anspruch 1 oder Anspruch 2, **dadurch gekennzeichnet, dass** die besagte Harzzusammensetzung (E) aus 20 bis 85 Gewichtsprozent (A), 5 bis 40 Gewichtsprozent (B) und 10 bis 75 Gewichtsprozent (C) zusammengesetzt ist und (D) in einem äquivalenten Verhältnis von 0,5 bis 2 pro 1 Äquivalent Epoxygruppen enthaltend in (E) umfasst.

4. Das weiße Prepreg gemäß einem der Ansprüche 1 bis 3, **dadurch gekennzeichnet, dass** das besagte cycloaliphatische Epoxy (Al) eine durch die folgende Formel (I) dargestellte Struktur hat: 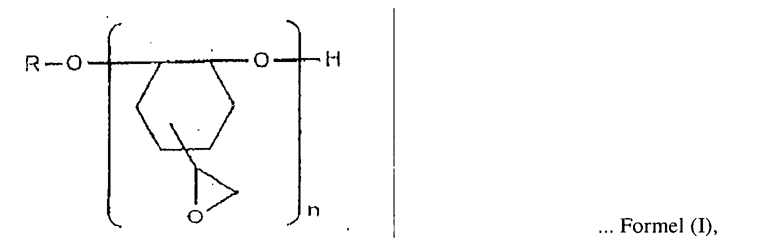 worin R Wasserstoff oder eine Alkylgruppe einer linearen Kette oder verzweigten Kette mit 1 bis 5 Kohlenstoffatomen darstellt und n eine ganze Zahl von 1 bis 30 darstellt.

5. Das weiße Prepreg gemäß einem der Ansprüche 1 bis 4, **dadurch gekennzeichnet, dass** das besagte Glycidyl(meth)acrylat-Polymer (B) ein Glycidyl(meth)acrylat-Homopolymer ist.

6. Das weiße Prepreg gemäß einem der Ansprüche 1 bis 4, **dadurch gekennzeichnet, dass** das besagte Glycidyl(meth)acrylat-Polymer (B) ein Copolymer von Glycidyl(meth)acrylat und einem radikalisch polymerisierbaren Monomer ist.

7. Das weiße Prepreg gemäß einem der Ansprüche 1 bis 6, **dadurch gekennzeichnet, dass** das besagte weiße Pigment (C) eines ist, ausgewählt aus der Gruppe bestehend aus Zinkoxid, Calciumcarbonat, Titandioxid, Aluminiumoxid und synthetischem Smektit oder einer Mischung von zwei oder mehr derselben.

8. Das weiße Prepreg gemäß einem der Ansprüche 1 bis 6, **dadurch gekennzeichnet, dass** das besagte weiße Pigment Titandioxid ist.

9. Das weiße Prepreg gemäß einem der Ansprüche 1 bis 8, **dadurch gekennzeichnet, dass** der besagte Härter (D) ein latenter Härter ist.

10. Ein weißes Laminat, welches ein Produkt umfasst, das durch Druckformung unter Erwärmung einer Lage oder mehrerer Lagen eines weißen Prepregs gemäß einem der Ansprüche 1 bis 9 erhältlich ist.

11. Ein mit einer Metallfolie kaschiertes weißes Laminat, welches ein Produkt umfasst, das durch Druckformung unter Erwärmung eines Laminats umfassend eine Lage oder mehrere Lagen eines weißen Prepregs gemäß einem der Ansprüche 1 bis 9 mit einer hierauf aufgebrachten Metallfolie erhältlich ist.

12. Eine Leiterplatte zur Montage einer chipartigen Leuchtdiode, wobei besagte Platte ein darin verwendetes, weißes Laminat gemäß Anspruch 10 umfasst.

13. Eine Leiterplatte zur Montage einer chipartigen Leuchtdiode, wobei besagte Platte ein darin verwendetes, mit einer Metallfolie kaschiertes weißes Laminat gemäß Anspruch 11 umfasst.

## Revendications

1. Préimprégné blanc, qui comprend un produit séché d'une composition à base de résine (E) imprégnée sur un substrat feuille en fibre de verre, ladite composition (E) contenant, comme composants principaux, une résine époxy (A) comprenant une résine époxy cycloaliphatique (A1), un polymère de glycidyl(méth)acrylate (B), un pigment blanc (C), et un durcisseur (D).

2. Préimprégné blanc selon la revendication 1, dans lequel ladite résine époxy (A) comprenant un époxy cycloaliphatique (A1) contient une résine époxy (A2) de type général, sélectionnée dans le groupe constitué d'un éther diglycidylique d'un bisphénol, d'une résine novolaque d'un phénol, d'une glycidylamine et d'un ester glycidylique, dans une quantité de 5 à 60% en poids par rapport à ladite résine époxy (A).

3. Préimprégné selon la revendication 1 ou la revendication 2, dans lequel ladite composition à base de résine (E) est composée de 20 à 85% en poids de (A), 5 à 40% en poids de (B) et 10 à 75% en poids de (C), et contient (D) dans un rapport équivalent de 0,5 à 2 pour 1 équivalent au groupe époxy contenu dans (E).

4. Préimprégné blanc selon l'une quelconque des revendications 1 à 3, dans lequel ledit époxy cycloaliphatique (A1) a une structure représentée par la formule suivante (1) : 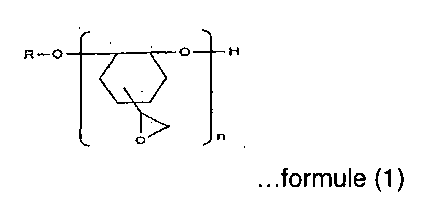 où R représente l'hydrogène ou un groupe alkyle de chaîne droite ou de chaîne ramifiée contenant 1 à 5 atomes de carbone, et n représente un entier de 1 à 30.

5. Préimprégné blanc selon l'une quelconque des revendications 1 à 4, dans lequel ledit polymère de glycidyl(méth)acrylate (B) est un homopolymère de glycidyl(méth)acrylate.

6. Préimprégné blanc selon l'une quelconque des revendications 1 à 4, dans lequel ledit polymère de glycidyl(méth)acrylate (B) est un copolymère de glycidyl(méth)acrylate avec un monomère polymérisable radicalaire.

7. Préimprégné blanc selon l'une quelconque des revendications 1 à 6, dans lequel ledit pigment blanc est sélectionné dans le groupe constitué de l'oxyde de zinc, du carbonate de calcium, du dioxyde de titane, d'alumine et de smectite synthisée, ou d'une combinaison de deux ou de plusieurs de ceux-ci.

8. Préimprégné blanc selon l'une quelconque des revendications 1 à 6, dans lequel ledit pigment blanc (C) est le dioxyde de titane.

9. Préimprégné blanc selon l'une quelconque des revendications 1 à 8, dans lequel ledit durcisseur (D) est un durcisseur latent.

10. Stratifié blanc, qui comprend un produit pouvant être obtenu par moulage sous pression et chauffage d'au moins une ou plusieurs feuilles d'un préimprégné blanc selon l'une quelconque des revendications 1 à 9.

11. Stratifié blanc sur lequel est plaquée une feuille métallique, lequel comprend un produit pouvant être obtenu par moulage sous pression et chauffage d'au moins une ou plusieurs feuilles d'un préimprégné blanc selon l'une quelconque des revendications 1 à 9 et sur lequel est disposé une feuille métallique.

12. Carte de circuit imprimé pour le montage d'une diode photoémettrice de type puce, ladite carte comprenant un stratifié blanc selon la revendication 10 utilisée ici.

13. Carte de circuit imprimé pour le montage d'une diode photoémettrice de type puce, ladite carte comprenant un stratifié blanc sur lequel est plaquée une feuille métallique selon la revendication 11 utilisée ici.
